Europäisches Patentamt

European Patent Office

Office européen des brevets

(19)

(11) Publication number: **0 329 274**
**A1**

## (12) EUROPEAN PATENT APPLICATION

(21) Application number: **89300446.5**

(22) Date of filing: **18.01.89**

(51) Int. Cl.⁴: **H01L 21/88 , H01L 21/316 , G02F 1/133**

(30) Priority: **19.02.88 JP 35456/88**

(43) Date of publication of application:
**23.08.89 Bulletin 89/34**

(84) Designated Contracting States:
**DE FR GB IT**

(71) Applicant: **International Business Machines Corporation**
**Old Orchard Road**
**Armonk, N.Y. 10504(US)**

(72) Inventor: **Furuta, Kaoru**
**20-4 Tsurugaoka Danchi 4-13 Minamidai**
**Sagamihara-shi Kanagawa-ken(JP)**
Inventor: **Yoshida, Toshihiko**
**A201 Corpo Narushisu 2-7-7 Shinishikawa**
**Midori-ku**
**Yokohama-shi Kanagawa-ken(JP)**

(74) Representative: **Hobbs, Francis John**
**IBM United Kingdom Limited Intellectual**
**Property Department Hursley Park**
**Winchester Hampshire SO21 2JN(GB)**

(54) **A method of forming anodised regions on an anodisable metal layer.**

(57) An insulating layer (2) is deposited by a vapour deposition (e.g. plasma CVD) process on a layer (1) of an anodisable metal and regions (4) of the anodisable metal exposed by apertures in the insulating layer are anodised.

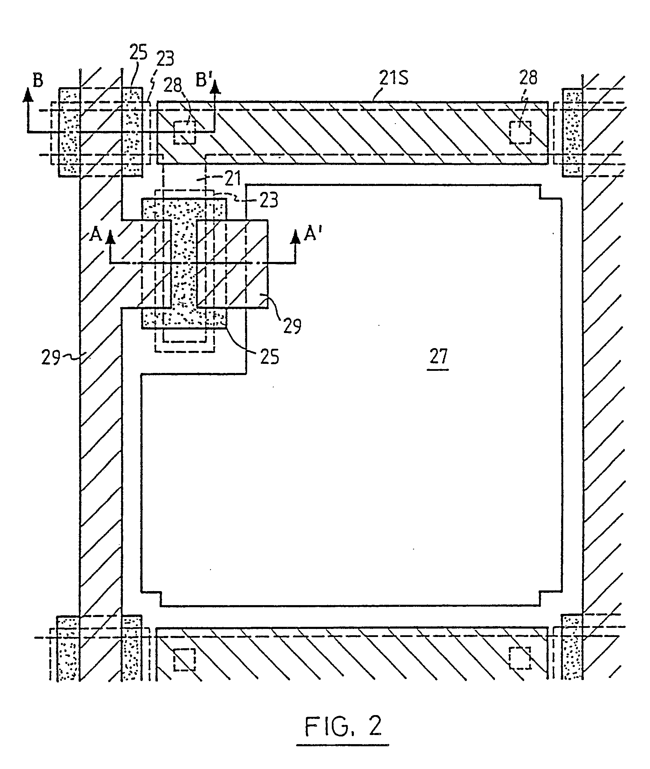

The anodisable metal layer may be in the form of a set of electrode lines in a liquid crystal display device. In one such liquid crystal display device (Figs. 2, 3 and 4), active switching elements are formed on some anodised regions of the metal layer and a second set of electrode lines intersects the first set of electrode lines at other anodised regions of the metal layer.

FIG. 1B·

# A METHOD OF FORMING ANODISED REGIONS ON AN ANODISABLE METAL LAYER

This invention relates to a method of forming anodised regions on an anodisable metal layer.

Recently, active matrix liquid crystal display devices have been developed as high density, large area liquid display devices. Since the active matrix system has active switching elements provided for each picture element to maintain voltage, and voltage on selection can be maintained even in time-sharing driving, display capacity may be increased and properties related to picture quality, such as contrast and view angles, may be improved.

Well-known active matrix liquid crystal display devices include a thin film transistor active matrix liquid crystal display device (hereafter called TFT/LCD) having thin film transistors (hereafter abbreviated as TFTs) using hydrogenated amorphous silicon (hereafter abbreviated as a-Si:H) as active switching elements.

In order to achieve high density and large area in TFT/LCDs, the dielectric strength of insulation layers of MIS (metal-insulator-semiconductor) structure constituting TFT and of interlayer insulation layers on the areas where scanning electrode lines intersect signal electrode layers must be sufficiently high. Published Unexamined Japanese Patent Application No. 62-65468 (65468/87) discloses a method of increasing the dielectric strength of such areas by partially anodising TFT formation regions of Ta (tantalum) layers constituting gate electrodes (i.e., scanning electrode lines) and intersecting regions of the Ta layers at which drain electrodes (i.e., signal electrode lines) intersect.

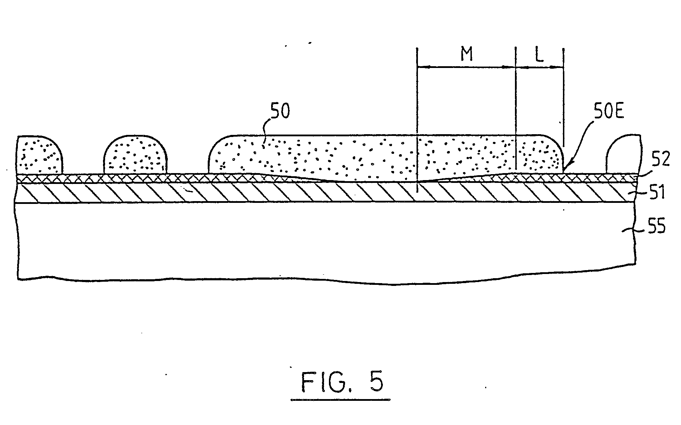

Although the above Published Unexamined Japanese Patent Application No. 62-65468 disclosed the use of a photoresist as a mask for partial anodic oxidation, the inventors' experiments revealed that the photoresist is almost ineffective for anodic oxidation. For example, when the thickness of the photoresist is 1.5 $\mu$m and the conversion voltage is 100 volts, as Figure 5 of the accompanying drawings illustrates, an anodised layer 52 of the same thickness as that of the region not covered with the photoresist 50 is formed (permeated) for a distance of about 30 $\mu$m (which is L in Figure 5) on the electrode line 51 consisting of an anodisable metal provided on a transparent glass substrate 55 underneath the region covered with the photoresist 50 from the edge 50E of the photoresist 50, from which an anodised layer 52 with decreasing thickness is also formed for a distance of about 60 $\mu$m (which is M in Figure 5) underneath the region covered with the photoresist 50. Since the length of a side of a picture element of a currently proposed liquid crystal display de-

vice is 200 $\mu$m, and this length is expected to be reduced in future devices, the formation of the anodised layer 52 for a distance of about 90 $\mu$m on the region covered with the photoresist as described above is not tolerable. That is, the formation of an anodised layer on a region other than the desired regions increases the resistance of electrode lines and limits the sites where contact holes can be formed. If the size of the liquid crystal display device is further reduced, whole electrode lines are anodised resulting in extremely high resistance, and the formation of contact holes becomes impossible.

This invention seeks to provide a method of producing a metal insulation structure in which anodised layers are formed on the desired regions but not around such regions.

The invention provides a method of forming anodised regions on an anodisable metal layer, comprising depositing an insulating layer on the anodisable metal layer, forming apertures in the insulating layer and anodising the anodisable metal exposed by the apertures in the insulating layer, the method being characterised by the insulating layer being deposited on the anodisable metal layer by a vapour deposition process.

The inventors have discovered in anodic oxidation using a conversion voltage as high as 100 volts, that the region of anodisable metal layer covered with a vapour-grown insulation layer is not anodised. It is considered that because the vapour-grown insulation layer is dense and has high dielectric strength and small leakage current, the layer functions as a protective mask even when a conversion voltage as high as 100 volts is impressed.

Since the metal insulation structure made by a method according to this invention has vapour-grown insulation layers having apertures, deposited on an anodisable metal layer, and these vapour-grown insulation layers act as protective masks against anodic oxidation, anodised layers formed by converting at least the surface areas of said metal layers can be limited to areas of the metal layers defined by the apertures in the vapour-grown insulation layers.

A liquid crystal display device made by a method embodying this invention firstly has vapour-grown insulation layers having apertures on the region where active switching elements are provided, deposited on electrode lines consisting of an anodisable metal, and these vapour-grown insulation layers act as protective masks against anodic oxidation. The anodised layers formed by converting at least the surface areas of the electrode lines can be limited to regions of the electrode lines defined by the apertures of the vapour-grown insulation layers, that is, the regions where active switching elements are formed.

A liquid crystal display device made by a method embodying this invention secondly has vapour-grown insulation layers having apertures on the areas where first electrode lines intersect second electrode lines, deposited on the first electrode lines consisting of an anodisable metal. The anodised layers formed by converting at least the surface areas of the first electrode lines can be limited to the first electrode lines located in the apertures of the vapour-grown insulation layers.

How the invention can be carried out will now be described by way of example, with reference to Figures 1 to 4 of the accompanying drawings, in which:-

Figures 1A, 1B and 1C represent cross-sections of a metal insulator structure at successive stages in a method of forming anodised regions embodying the invention;

Figure 2 is a diagrammatic plan of an active matrix electrode substrate of a liquid crystal display device produced using the method illustrated in Figures 1A, 1B and 1C;

Figure 3 is a cross-section on the line A-A' of Figure 2;

Figure 4 is a cross section on the line B-B' of Figure 2; and

Figure 5 is a diagrammatic cross-section of an anodised layer formed by a prior art selective anodic oxidation method.

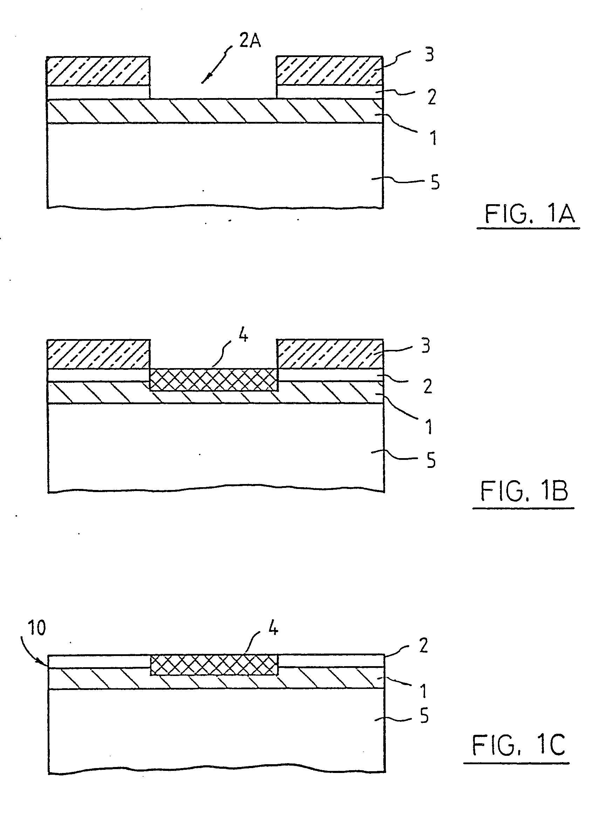

Figures 1A, 1B and 1C show cross-sectional views illustrating a process for producing a metal insulation structure embodying this invention, that is, an embodiment of the selective anodic oxidation of a metal in the order of processing. An anodisable metal layer 1 consisting of an alloy containing tantalum (Ta) of a predetermined thickness is formed on a transparent glass substrate 5 by a method such as sputtering. An insulation layer 2 consisting of $SiO_x$ of a predetermined thickness is then vapour- grown by a chemical vapour deposition (CVD) method at a temperature which the glass substrate 5 tolerates. An aperture of a photoresist 3 is then provided only on the region where anodic oxidation is required using photolithography, and the vapour-grown insulation layer on the region where anodic oxidation is required is removed by wet etching using a buffered hydrofluoric acid solution to form an aperture 2A in the vapour-grown insulation layer 2 (Figure 1A).

Then, the glass substrate 5 on which the anodisable metal layer 1, the vapour-grown insulation layer 2, and the photoresist 3 are deposited is immersed in an electrolyte suitable for the anodisable metal layer 1, and a current is applied between the metal layer 1 as the anode and a platinum (Pt) cathode to make oxygen ($O_2$) produced at the anode exposed to the electrolyte in the aperture 2A of the insulation layer 2 combine with the anodisable metal layer 1 exposed in the aperture 2A to form the anodised layer 4. The current decreases gradually, and the thickness of the anodised layer 4 is almost proportional to the voltage impressed between the anode and the cathode. If the anodised metal layer 1 consists of tantalum, the thickness will be about 100 nm when the conversion voltage is 60 volts and the thickness will be about 170 nm when the conversion voltage is 100 volts (Figure 1B).

While an alloy containing tantalum is used as the anodisable metal layer 1 in the above description, tantalum, niobium (Nb), or alloys containing niobium may be used. Also, while the insulation layer 2 is formed using the plasma CVD method in the above description, optical excitation or ECR plasma CVD methods may be used for the insulation layer 2. The insulation layer 2 may be made of $SiN_x$ instead of $SiO_x$. The vapour-grown insulation layer 2 may be removed also by plasma etching.

Finally, the photoresist 3 is removed to complete the selective anodic oxidation process (Figure 1C). The removal of the photoresist 3 may be performed after aperture etching of the insulation layer 2, and before anodic oxidation.

In the metal insulation structure 10 shown in Figure 1C, since the vapour-grown insulation layer 2 is deposited around the region where the anodic oxidation of the metal layer 1 is required, the anodised layer is formed only on the metal layer 1 exposed in the region where anodic oxidation is required, that is, in the aperture 2A of the vapour-grown insulation layer 2, the dielectric strength of only this region can be enhanced, and by adjusting the thickness of the vapour-grown insulation layer 2 and/or the anodised layer 4, a step may be removed or reduced.

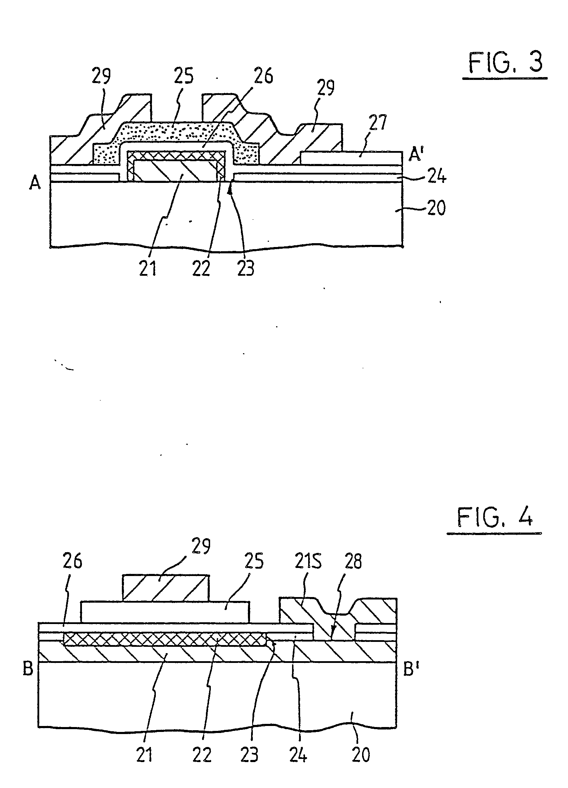

Figure 2 is a plan illustrating an embodiment of a liquid crystal display device produced by using the method shown in Figures 1A, 1B and 1C. Figure 3 is a cross-sectional view showing the cross section along line A-A' of Figure 2. Figure 4 is a cross-sectional view showing the cross section along line B-B' of Figure 2.

An example of the process for producing the active matrix electrode substrate shown in Figures 2, 3 and 4 will first be described. First, an alloy containing tantalum (Ta) of a thickness of about 300 nm is vapour-deposited on a transparent glass substrate 20 by sputtering, and a first layer scanning electrode line 21 is patterned by photolithography. A vapour-grown insulation layer 24 consisting of $SiO_x$ acting as an insulation layer for selective anodic oxidation is then deposited by a plasma CVD method, and selective anodic oxidation apertures 23 are patterned on the locations corresponding to TFT forming regions of the first layer scanning electrode line 21 and to intersection regions of the first layer scanning electrode line 21 and the signal electrode line 29 by photolithography. Then, by selective anodic oxidation described referring to Figures 1A, 1B and 1C, an anodised layer 22 consisting of $Ta_2O_5$ is converted on the first layer scanning electrode line 21 exposed in the aperture 23. The anodic oxidation of this embodiment is performed using a citric acid solution with a concentration of 0.01% by weight as the electrolyte at a temperature of 24° C, and the thickness of the layer converted is about 200 nm. It should be noted that only a part of the first layer scanning electrode line 21 is anodised in the thickness direction. This is because the MOS (metal-oxide-semiconductor) structure is not formed unless a metal layer to serve as the gate remains under the anodised layer 22 in the TFT forming region of the first layer scanning electrode line 21, and because said electrode line 21 becomes non-conductive if the electrode line 21 is anodised throughout the thickness direction at the intersection region of the first layer scanning electrode line 21 and the signal electrode line 29.

Next, using plasma CVD, about 100 nm of $SiO_x$ or $SiN_x$ is grown as the gate insulation layer 26, followed by the vapour-growing of about 300 nm of an a-Si:H layer by plasma CVD method, and the formation of islands 25 of a-Si:H on the TFT forming region and the intersection region of the first scanning electrode line 21 and the signal electrode line 29 by photolithography. Then, as the material for the transparent display electrode, about 200 nm of ITO (indium tin oxide) is vapour-deposited by sputtering, and the transparent display electrode 27 is patterned by photolithography. Then, a contact hole 28 is patterned on the first layer scanning electrode line 21 for the electrical connection with a second layer scanning electrode line 21S by photolithography to form the aperture. Then, about 1000 nm of aluminium (Al) is vapour deposited by sputtering as the material for the signal electrode line 29 and the second layer scanning electrode line 21S, and finally, the signal electrode line 29 and the second layer scanning electrode 21S are patterned to complete the active matrix electrode substrate except for the process for orientation of liquid crystals.

In the active matrix electrode substrate of the liquid crystal display device shown in Figures 2, 3 and 4 thus produced, since the anodised layers 22 are formed on the TFT forming regions of the first layer scanning electrode line 21, and the intersecting regions of the first layer scanning electrode line 21 and the signal electrode line 29, the dielectric strength at the TFT area and the electrode line intersecting region can be enhanced, and since the vapour-grown insulation layers 22 each acting as an insulation layer for selective anodic oxidation are deposited around the TFT forming regions and around the electrode line intersecting regions, the formation of anodised layers 22 are limited to the regions of the first layer scanning electrode lines 21 exposed in the apertures 23 for selective anodic oxidation, that is, the TFT forming regions and the electrode line intersecting regions. Thus, the freedom of the locations where the contact holes 28 are formed is ensured without an unnecessary increase in the resistance of the first layer scanning electrode 21.

The scanning electrode has a two-layer structure. The first layer scanning electrode line 21 also acts as the TFT gate electrode and extends laterally, while the second layer scanning electrode line 21S is electrically connected to the first layer scanning electrode line 21 through the contact hole 28. The presence of this second layer scanning electrode line 21S decreases the resistance of the entire scanning electrode line.

The step produced on the pattern cross section of the first layer scanning electrode line 21 can be reduced by the deposition of the vapour-grown insulation layer 24 or by opening an aperture on this layer 24, at the intersection regions of the scanning electrode line 21 and the signal electrode line 29, at the regions of the source electrode of the TFT (lefthand signal electrode line 29 in Figure 3), and the drain electrode of the TFT (righthand signal electrode line 29 in Figure 3), resulting in the improvement of step coverage in these regions.

Although the thickness of the vapour-grown insulation layer 24 is about 150 nm and the thickness of the anodised layer 22 is about 200 nm in the above embodiment, this invention is not limited to those values. The thickness of both the vapour-grown insulation layer 24 and the anodised layer 22 can freely be determined within the range between 50 and 500 nm, depending on design conditions. The concentration of the citric acid solution used as the electrolyte may be between 0.001 and 5.0% by weight, and the temperature between 20 and 30° C.

While the above description relates to a liquid crystal display device using a TFT as the active switching element, it will be obvious to those skilled in the art that this invention can be applied to active matrix liquid crystal display devices using MIM elements to improve the dielectric strength of insulation layers and to reduce the resistance of scanning electrode lines.

In applying the invention to the manufacture of liquid crystal display devices, the formation of anodised layers are limited to the regions of electrode lines where active switching elements are formed, and where other electrode lines intersect, and so the dielectric strength of those anodised regions can be enhanced and the increase in resistance of unnecessary electrode lines can be prevented, thus ensuring freedom in choosing the locations of contact holes.

Claims

1. A method of forming anodised regions on an anodisable metal layer (1), comprising depositing an insulating layer (2) on the anodisable metal layer, forming apertures (2A) in the insulating layer and anodising the anodisable metal exposed by the apertures in the insulating layer, the method being characterised by the insulating layer being deposited on the anodisable metal layer by a vapour deposition process.

2. A method as claimed in claim 1, in which the insulating layer is deposited by a plasma CVD method.

3. A method as claimed in claim 1, in which the insulating layer is deposited by an optical excitation CVD method.

4. A method as claimed in claim 1, in which the insulating layer is deposited by an ECR plasma CVD method.

5. A method as claimed in any preceding claim, in which the deposited insulating layer is composed of $SiO_x$ or $SiN_x$.

6. A method of forming a liquid crystal display device having electrode lines consisting of an anodisable metal provided on a substrate, and active switching elements provided on predetermined anodised regions of the electrode lines, in which the anodised regions of the electrode lines are formed by a method as claimed in any preceding claim.

7. A method of forming a liquid crystal display device having a first set of electrode lines consisting of an anodisable metal provided on a substrate, and a second set of electrode lines intersecting the first set of electrode lines, the second electrode lines being insulated from the first electrode lines by anodised regions of the first electrode lines, in which the anodised regions of the first electrode lines are formed by a method as claimed in any of claims 1 to 5.

2A

3

2

1

5

FIG. 1A

4

3

2

1

5

FIG. 1B

10

4

2

1

5

FIG. 1C

FIG. 2

FIG. 3

FIG. 4

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-1 535 086 (WESTERN ELECTRIC CO.) * Page 2, lines 8-28 * | 1,5 | H 01 L 21/88<br>H 01 L 21/316<br>G 02 F 1/133 |
| Y | --- | 2-4,6,7 | |
| Y | JAPANESE JOURNAL OF APPLIED PHYSICS. SUPPLEMENTS, 1983, suppl. 15th conf., pages 117-120, Tokyo, JP; M. HATANAKA et al.: "Photo-CVD silicon nitride and silicon oxide films for VLSI application" * Abstract; introduction section * --- | 2,3 | |
| X | US-A-4 401 054 (MATSU et al.) * Abstract; column 15, lines 43-49 * --- | 4 | |
| Y,D | PATENT ABSTRACTS OF JAPAN, vol. 11, no. 254 (E-533)[2701], 18th August 1987; & JP-A-62 65 468 (TOSHIBA CORP.) 24-03-1987 * Abstract * ----- | 6,7 | |

TECHNICAL FIELDS
SEARCHED (Int. Cl.4)

H 01 L
C 23 C

The present search report has been drawn up for all claims

| Place of search | Date of completion of the search | Examiner |
|---|---|---|
| THE HAGUE | 26-05-1989 | PATTERSON A.M. |

EPO FORM 1503 03.82 (P0401)